# EUROPEAN PATENT APPLICATION

(11) **EP 3 722 382 A1**
(43) Date of publication of application: **14.10.2020**
(21) Application number: 18886221.3
(22) Date of filing: 29.11.2018
(51) Int. Cl.: C09D 11/52, B22F 1/00, B22F 1/02, B22F 7/04, B82Y 30/00, B82Y 40/00, C09D 11/30, H01B 1/00, H01B 1/22, H01B 5/14, H01B 13/00, H05K 1/09, H05K 3/10, B22F 9/30

(54) **INKJET PRINTING INK**

(30) Priority: 07.12.2017 JP 2017234967; 07.12.2017 JP 2017234968
(71) Applicant: Daicel Corporation, Osaka-shi, Osaka 530-0011 (JP)
(72) Inventor: IGUCHI, Yuki, Tokyo 108-8230 (JP); OKAMOTO, Kazuki, Tokyo 108-8230 (JP)
(74) Representative: Grünecker Patent- und Rechtsanwälte PartG mbB
(86) International application number: PCT/JP2018/043950
(87) International publication number: WO 2019/111795

(57) **Abstract**

Provided is an ink for use in manufacturing electronic components via inkjet printing, the ink being capable of stably maintaining silver nanoparticle dispersibility for extended periods, even in the presence of oxygen, and can be sintered to obtain a sintered body exhibiting superior electrical conductivity. The ink according to the present invention is an inkjet printing ink comprising surface-modified silver nanoparticles (A) and a dispersion solvent (B), wherein the (A) are surface-modified silver nanoparticles having a configuration in which surfaces of the silver nanoparticles are coated with a protective agent containing an amine; an amount of the (A) (in terms of silver) is not less than 30 wt.% of the ink; and the (B) comprises a secondary alcohol and/or a tertiary alcohol (b-1), and a hydrocarbon (b-2), wherein a total amount of the (b-1) and the (b-2) is not less than 70 wt.% of a total amount of the dispersion solvent (B).

## Description

### Technical Field

The present invention relates to an ink used in applications for producing electronic components by an inkjet printing method. The present application claims priority to JP 2017-234967 and JP 2017-234968 filed in Japan on December 7, 2017, the contents of which are incorporated herein.

### Background Art

Electronic components, such as circuits, wiring, and electrodes, have been produced by an etching method in the art. However, the production process has been complicated, increasing the cost. To overcome this problem, an alternative method has been studied, in which a conductive material is adhered onto a substrate by a printing method to directly form an electronic component.

Among conductive materials, for example, bulk silver has a high melting point of 962°C, but nano-sized silver particles (silver nanoparticles) fuse together at a temperature of approximately 100°C. Thus, use of silver nanoparticles can form an electronic component with excellent conductivity on a commodity plastic substrate with low heat resistance. However, a problem with the silver nanoparticles is that they are prone to agglomeration.

Patent Document 1 describes that coating the surfaces of the silver nanoparticles with a protective agent containing amines can prevent agglomeration of the silver nanoparticles; an ink obtained by dispersing the surface-modified silver nanoparticles thus obtained in a dispersion solvent containing from 10 to 50 wt.% of a hydrocarbon, such as, for example, n-octane, decalin, or tetradecane, and 50 to 90 wt.% of an alcohol, such as, for example, n-butanol or cyclohexanemethanol, is excellent in dispersion stability of the silver nanoparticles and can be suitably used in applications to directly form electronic components by a printing method; and sintering the ink can provide a sintered body with excellent conductivity.

### Citation List

### Patent Documents

Patent Document 1: WO 2015/060084

### Summary

### Technical Problem

However, the ink described in Patent Document 1 can maintain the dispersion state stably over time in the absence of oxygen, but it was found that the dispersibility gradually decreases in contact with oxygen, and agglomeration of the silver nanoparticles proceeds.

In addition, formation of a coating film with high film thickness by an inkjet printing method requires increasing the silver concentration in the ink, but the increased silver concentration causes problems in that the nozzle of the inkjet head is prone to clogging, and the ejection becomes unstable.

As a matter of fact, the ink described in Patent Document 1 provides good ejection stability at a silver concentration of approximately 40 wt.%, but it has been found that with the increased silver concentration, the ink is prone to solidify and adhere to the nozzle orifice of the inkjet head, and this destabilizes the ejection particularly when the ejection is intermittent, causing difficulty in accurately printing the desired pattern due to flight bending (ejection at a different angle from a predetermined ejection angle), or clogging the nozzle orifice and disabling the ejection.

In addition, to ensure the ejection stability of the ink with a high silver concentration, it is conceivable that the dispersion solvent contained in the ink is changed to a dispersion solvent hard to volatilize (e.g., a dispersion solvent having a higher boiling point than dispersion media known in the art). However, it has been found that only with such a measure particularly in low-temperature sintering, the evaporation of the dispersion solvent from the silver coating film drawn by an inkjet printing method may be delayed, and this may reduce sintering properties of the silver nanoparticles and the conductivity of the resulting sintered body.

Thus, an object of the present invention is to provide an ink (conductive ink) used in applications for producing electronic components by an inkjet printing method, the ink being capable of maintaining the dispersibility of the silver nanoparticles stably for a long period of time even in the presence of oxygen and providing a sintered body with excellent conductivity by sintering.

Another object of the present invention is to provide an ink (conductive ink) used in applications for producing electronic components by an inkjet printing method, the ink containing a high concentration of silver nanoparticles and excellent in ejection stability and low-temperature sintering properties.

Still another object of the present invention is to provide a method for producing an electronic device using the ink.

Yet another object of the present invention is to provide an electronic device including a sintered body of the ink.

### Solution to Problem

As a result of diligent research to solve the problems described above, the present inventors found the following.
1. An ink obtained by dispersing silver nanoparticles coated with a protective agent containing an amine in a dispersion solvent containing an alcohol and a hydrocarbon is activated by the contact of the silver with oxygen to act as a catalyst to promote oxidation reaction of the alcohol.
2. In using a primary alcohol as the alcohol, the primary alcohol is prone to oxidation and oxidized into an aldehyde, and the aldehyde readily reacts with the amine as the protective agent for the silver nanoparticles to form an imine, thus reducing the amine as the protective agent and in turn reducing the dispersibility of the silver nanoparticles, and destabilizing the ejection.
3. In using a secondary or tertiary alcohol as the alcohol, such an alcohol is less likely to be oxidized, and if oxidized, the alcohol is turned into a ketone, and the ketone is less reactive with an amine compared with an aldehyde, and thus this can prevent reducing the amine as the protective agent for the silver nanoparticles, maintain the dispersibility of the silver nanoparticles stably for a long period of time, and provide ejection stability.
4. Use of an alcohol and a hydrocarbon having reasonably high boiling points can prevent the dispersion solvent from volatizing during printing, thus preventing the ink from solidifying and clogging the nozzle orifice of the inkjet head. This can stably maintain excellent ejection properties and can form a sintered body with excellent conductivity even by low-temperature sintering.

The present invention was completed based on these findings.

In the present specification, the "nanoparticles" mean particles having a primary particle size (average primary particle diameter) of less than 1000 nm. In addition, the particle diameter is determined by dynamic light scattering. Furthermore, the boiling point in the present specification is a value under normal pressure (760 mmHg).

That is, an embodiment of the present invention provides an inkjet printing ink containing surface-modified silver nanoparticles (A) and a dispersion solvent (B), in which
the surface-modified silver nanoparticles (A) are surface-modified silver nanoparticles having a configuration in which surfaces of the silver nanoparticles are coated with a protective agent containing an amine;
an amount of the surface-modified silver nanoparticles (A) (in terms of silver) is not less than 30 wt.% of a total amount of the ink; and
the dispersion solvent (B) contains a secondary alcohol and/or a tertiary alcohol (b-1), and a hydrocarbon (b-2), in which a total amount of the (b-1) and the (b-2) is not less than 70 wt.% of a total amount of the dispersion solvent (B).

An embodiment of the present invention also provides the ink, in which an amount of the surface-modified silver nanoparticles (A) (in terms of silver) is greater than 40 wt.% and not greater than 70 wt.% of the total amount of the ink.

An embodiment of the present invention also provides the ink, in which the secondary alcohol and/or the tertiary alcohol (b-1) are/is a secondary alcohol and/or a tertiary alcohol having a boiling point of not lower than 185°C.

An embodiment of the present invention also provides the ink, in which the hydrocarbon (b-2) has a boiling point of not lower than 200°C.

An embodiment of the present invention also provides the ink, in which the (b-1) are/is an alicyclic secondary alcohol and/or an alicyclic tertiary alcohol.

An embodiment of the present invention also provides the ink, in which the protective agent in the surface-modified silver nanoparticles (A) contains, as amines, an aliphatic monoamine (1) having 6 or more carbon atoms in total, and an aliphatic monoamine (2) having 5 or less carbon atoms in total and/or an aliphatic diamine (3) having 8 or less carbon atoms in total.

An embodiment of the present invention also provides the ink, in which a ratio of contents of the (b-1) and the (b-2) (the former/the latter (weight ratio)) in the dispersion solvent (B) is from 50/50 to 95/5.

An embodiment of the present invention also provides the ink, in which a sintered body obtained by sintering at 120°C for 30 minutes has a volume resistivity of not greater than 15 µΩcm.

An embodiment of the present invention also provides a method for producing an electronic device, the method including: providing the ink onto a substrate by an inkjet printing method; and sintering.

An embodiment of the present invention also provides an electronic device including a sintered body of the ink on a substrate.

### Advantageous Effects of Invention

The ink according to an embodiment of the present invention has excellent dispersion stability and can prevent agglomeration of the silver nanoparticles over a long period of time even in the presence of oxygen. Thus, the ink, when used in inkjet printing applications, has good ejection properties stably for a long period of time, and this prevents the ink from solidifying and adhering to the nozzle orifice of the inkjet head not only when the ejection is continuous but also when the ejection is intermittent, allowing accurate printing without causing flight bending or disabling the ejection. In addition, the ink according to an embodiment of the present invention forms a sintered body with excellent conductivity by sintering (even by low-temperature sintering) after coated onto the substrate surface. Thus, the ink according to an embodiment of the present invention can be suitably used in applications for producing electronic components (e.g., such as circuits, wiring, and electrodes) on plastic substrates using an inkjet printing method.

### Description of Embodiments

### Inkjet printing ink

An ink according to an embodiment of the present invention is an inkjet printing ink containing surface-modified silver nanoparticles (A) and a dispersion solvent (B), in which
the surface-modified silver nanoparticles (A) are surface-modified silver nanoparticles having a configuration in which surfaces of the silver nanoparticles are coated with a protective agent containing an amine;
an amount of the surface-modified silver nanoparticles (A) (in terms of silver) is not less than 30 wt.% of a total amount of the ink; and
the dispersion solvent (B) contains a secondary alcohol and/or a tertiary alcohol (b-1), and a hydrocarbon (b-2), in which a total amount of the secondary alcohol and/or the tertiary alcohol (b-1) and the hydrocarbon (b-2) is not less than 70 wt.% of a total amount of the dispersion solvent (B).

### Surface-modified silver nanoparticles (A)

The surface-modified silver nanoparticles (A) in an embodiment of the present invention have a configuration in which the surfaces of the silver nanoparticles are coated with a protective agent containing an amine, more specifically, a configuration in which unshared electron pairs of the amine are electrically coordinated to the silver nanoparticle surfaces. Thus, the surface-modified silver nanoparticles (A) in an embodiment of the present invention can provide space between the silver nanoparticles and can prevent re-agglomeration. That is, the surface-modified silver nanoparticles (A) in an embodiment of the present invention have excellent dispersibility.

The surface-modified silver nanoparticles (A) include a silver nanoparticle portion and a surface modification portion that coats the silver nanoparticle portion (i.e., the portion that coats the silver nanoparticles and is formed of a protective agent containing an amine), and the proportion of the surface modification portion is, for example, approximately from 1 to 20 wt.% (preferably from 1 to 10 wt.%) of the weight of the silver nanoparticle portion. Each weight of the silver nanoparticle portion and the surface modification portion in the surface-modified silver nanoparticles can be determined, for example, from the weight loss rate in a certain temperature range by subjecting the surface-modified silver nanoparticles to thermogravimetry.

The average primary particle diameter of the silver nanoparticle portion in the surface-modified silver nanoparticles (A) is, for example, from 0.5 to 100 nm, preferably from 0.5 to 80 nm, more preferably from 1 to 70 nm, and even more preferably from 1 to 60 nm.

The surface-modified silver nanoparticles (A) used are preferably surface-modified silver nanoparticles obtained by the production method described below.

### Dispersion solvent (B)

The dispersion solvent (B) in an embodiment of the present invention is a dispersion solvent to disperse the surface-modified silver nanoparticles (A). The dispersion solvent (B) contains at least the secondary alcohol and/or the tertiary alcohol (b-1) and the hydrocarbon (b-2). One of the (b-1) and the (b-2) can be contained alone, or two or more of them can be contained in combination. The (b-1) and the (b-2) each alone may be a liquid or solid under normal temperature and normal pressure, but the dispersion solvent (B) containing these components together is a dispersion solvent in a liquid state (a liquid dispersion solvent) under normal temperature and normal pressure.

### Secondary alcohol and tertiary alcohol (b-1)

The secondary alcohol and the tertiary alcohol in the (b-1) each include an aliphatic alcohol, an alicyclic alcohol, and an aromatic alcohol, and among them, an alicyclic alcohol (i.e., an alcohol having an alicyclic structure) is preferred in terms of having excellent dispersibility of the surface-modified silver nanoparticles (A). Thus, the secondary alcohol in the (b-1) is preferably an alicyclic secondary alcohol, and the tertiary alcohol in the (b-1) is preferably an alicyclic tertiary alcohol.

The boiling point of the (b-1) is, for example, not lower than 75°C, preferably not lower than 80°C, more preferably not lower than 130°C, particularly preferably not lower than 170°C, and most preferably not lower than 180°C.

When the ink according to an embodiment of the present invention contains a high concentration of the surface-modified silver nanoparticles (A) (e.g., the amount of the surface-modified silver nanoparticles (A) (in terms of silver) is greater than 40 wt.% of the total amount of the ink; which may be hereinafter referred to as the "high concentration ink"), the boiling point of the secondary alcohol and/or the tertiary alcohol (b-1) is preferably not lower than 185°C, particularly preferably not lower than 190°C, most preferably not lower than 200°C, and especially preferably not lower than 210°C. The upper limit of the boiling point is, for example, 300°C, preferably 250°C, and particularly preferably 220°C.

When the ink according to an embodiment of the present invention contains a medium concentration of the surface-modified silver nanoparticles (A) (e.g., the amount of the surface-modified silver nanoparticles (A) (in terms of silver) is from 30 to 40 wt.% of the total amount of the ink; which may be hereinafter referred to as the "medium concentration ink"), the boiling point of the secondary alcohol and/or the tertiary alcohol (b-1) is preferably not lower than 75°C, particularly preferably not lower than 150°C, most preferably not lower than 170°C, particularly preferably not lower than 186°C, and especially preferably not lower than 190°C. In addition, the upper limit of the boiling point is, for example, 250°C, preferably 210°C, and particularly preferably 200°C.

The boiling point of the (b-1) in the above range can prevent volatilization at a temperature during printing. In addition, the secondary alcohol and/or the tertiary alcohol (b-1) rapidly volatilize(s) even in low-temperature sintering, providing a sintered body with excellent conductivity. That is, the secondary alcohol and/or the tertiary alcohol (b-1) have/has both ejection stability and low-temperature sintering properties. On the other hand, the boiling point of the (b-1) below the above range would reduce the fluidity of the ink, and the ink would be prone to solidify and adhere to the nozzle orifice of the inkjet head, and this would destabilize the ejection particularly when the ejection is intermittent, causing difficulty in accurately printing the desired pattern due to flight bending, or clogging the nozzle orifice and disabling the ejection. In addition, the boiling point of the (b-1) exceeding the above range would delay the volatilization in low-temperature sintering, thus tending to be difficult to obtain a sintered body with excellent conductivity.

The alicyclic secondary alcohol is, for example, preferably cyclohexanol; a cyclohexanol that may have a substituent, such as 2-ethylcyclohexanol, 1-cyclohexylethanol, 3,5-dimethylcyclohexanol, 3,3,5-trimethylcyclohexanol, 2,3,5-trimethylcyclohexanol, 3,4,5-trimethylcyclohexanol, 2,3,4-trimethylcyclohexanol, 4-(tert-butyl)-cyclohexanol, 3,3,5,5-tetramethylcyclohexanol, or 2-isopropyl-5-methylcyclohexanol (i.e., menthol); or the corresponding cycloheptanol; in particular, preferably a cyclohexanol or cycloheptanol having an alkyl group having from 1 to 3 carbon atoms; and among them, a cyclohexanol having an alkyl group having from 1 to 3 carbon atoms is preferred.

The alicyclic tertiary alcohol is, for example, preferably a tertiary alcohol having a 6- to 7-membered ring (in particular, a cyclohexane ring) structure, such as 1-methylcyclohexanol, 4-isopropyl-1-methylcyclohexanol, 2-cyclohexyl-2-propanol, or 2-(4-methylcyclohexyl)-2-propanol.

The (b-1), in particular, preferably contain(s) at least a secondary alcohol (in particular, an alicyclic secondary alcohol) in terms of having excellent initial dispersibility of the surface-modified silver nanoparticles (A) and being able to maintain excellent dispersibility stably for a long period of time. The amount of the secondary alcohol is, for example, preferably from 60 to 100 wt.% of the (b-1), and the lower limit is more preferably 70 wt.%, particularly preferably 80 wt.%, and most preferably 90 wt.%.

### Hydrocarbon (b-2)

The (b-2) includes an aliphatic hydrocarbon, an alicyclic hydrocarbon, and an aromatic hydrocarbon. In an embodiment of the present invention, among them, an aliphatic hydrocarbon and/or an alicyclic hydrocarbon are/is preferred in terms of having particularly excellent dispersibility of the surface-modified silver nanoparticles (A).

For the same reasons as in the (b-1), the boiling point of the (b-2) is, for example, preferably not lower than 130°C, more preferably not lower than 170°C, even more preferably not lower than 190°C, and particularly preferably not lower than 200°C.

When the ink according to an embodiment of the present invention is the high concentration ink, the boiling point of the (b-2) is preferably not lower than 200°C, particularly preferably not lower than 250°C, most preferably not lower than 275°C, and especially preferably not lower than 280°C. In addition, the upper limit of the boiling point is, for example, 300°C.

When the ink according to an embodiment of the present invention is the medium concentration ink, the boiling point of the (b-2) is preferably not lower than 200°C, particularly preferably not lower than 250°C, most preferably not lower than 260°C, and especially preferably not lower than 265°C. In addition, the upper limit of the boiling point is, for example, 300°C, preferably 285°C, and particularly preferably 280°C.

The boiling point of the (b-2) in the above range can prevent volatilization at a temperature during printing. In addition, the hydrocarbon (b-2) rapidly volatilizes even in low-temperature sintering, providing a sintered body with excellent conductivity. That is, the hydrocarbon (b-2) has both ejection stability and low-temperature sintering properties. On the other hand, the boiling point of the (b-2) below the above range would reduce the fluidity of the ink, and the ink would be prone to solidify and adhere to the nozzle orifice of the inkjet head, and this would destabilize the ejection particularly when the ejection is intermittent, causing difficulty in accurately printing the desired pattern due to flight bending, or clogging the nozzle orifice and disabling the ejection. In addition, the boiling point of the (b-2) exceeding the above range would delay the volatilization in low-temperature sintering, thus tending to be difficult to obtain a sintered body with excellent conductivity.

The aliphatic hydrocarbon is, for example, preferably a chain aliphatic hydrocarbon having 10 or more (e.g., from 10 to 20) carbon atoms, such as n-decane, n-dodecane, n-tridecane, n-tetradecane, n-pentadecane, n-hexadecane, n-heptadecane, n-octadecane, and n-nonadecane, and among them, a chain aliphatic hydrocarbon having 12 or more (e.g., from 12 to 20 and preferably from 12 to 18) carbon atoms, and in particular, 15 or more (e.g., from 15 to 20 and preferably from 15 to 18) carbon atoms are preferred.

Examples of the alicyclic hydrocarbon include monocyclic compounds, such as cyclohexanes, cyclohexenes, terpene-based 6-membered ring compounds, cycloheptane, cycloheptene, cyclooctane, cyclooctene, cyclodecane, and cyclododecene; and polycyclic compounds, such as bicyclo[2.2.2]octane and decalin.

Examples of the cyclohexanes include compounds with a 6-membered ring having an alkyl group having 2 or more (e.g., from 2 to 5) carbon atoms, such as ethylcyclohexane, n-propylcyclohexane, isopropylcyclohexane, n-butylcyclohexane, isobutylcyclohexane, sec-butylcyclohexane, and tert-butylcyclohexane; and bicyclohexyl.

Examples of the terpene-based 6-membered ring compounds include α-pinene, β-pinene, limonene, α-terpinene, β-terpinene, γ-terpinene, and terpinolene.

The ink according to an embodiment of the present invention contains, as the dispersion solvent (B), the (b-1), and the (b-2) in combination. Thus, the ink has excellent dispersibility and dispersion stability of the surface-modified silver nanoparticles (A). This is because that the (b-1) are/is less likely to be oxidized compared with a primary alcohol, and if oxidized, the alcohol is turned into a ketone, and the ketone is less reactive with an amine compared with an aldehyde, an oxide of a primary alcohol, and thus this can prevent reducing the amine as the protective agent for the silver nanoparticles and can reduce the loss of the surface modification portion of the silver nanoparticles, the surface modification portion having an effect of preventing agglomeration of the silver nanoparticles.

A ratio of contents of the (b-1) and the (b-2) (the former/the latter (weight ratio)) in the dispersion solvent (B) is, for example, from 50/50 to 95/5, preferably from 60/40 to 90/10, particularly preferably from 65/35 to 85/15, and most preferably from 70/30 to 80/20. The amount of the (b-1) below the above range would tend to reduce the smoothness of the coating film and additionally would tend to reduce the low-temperature sintering properties. On the other hand, the amount of the (b-2) below the above range would tend to reduce the ejection stability.

The dispersion solvent (B) according to an embodiment of the present invention may contain one or two or more additional dispersion media in addition to the (b-1) and the (b-2), but the amount of such an additional dispersion solvent (the total amount of the additional dispersion media when two or more additional dispersion media are contained) is, for example, not greater than 30 wt.%, preferably not greater than 25 wt.%, particularly preferably not greater than 20 wt.%, and most preferably not greater than 15 wt.% of the total amount of the dispersion solvent (B). With the amount of the additional dispersion solvent exceeding the above range, the ejection properties would decrease due to thickening, or the silver nanoparticles would be prone to agglomeration, tending to reduce the dispersibility.

In addition, the dispersion solvent (B) in an embodiment of the present invention may contain a primary alcohol, but the amount of the primary alcohol is not greater than 30 wt.% of the total amount of the dispersion solvent (B) (or the total amount of the (b-1) and the (b-2)), and preferably not greater than 25 wt.%, more preferably not greater than 20 wt.%, even more preferably not greater than 15 wt.%, particularly preferably not greater than 10 wt.%, most preferably not greater than 5 wt.%, and especially preferably not greater than 3 wt.%. The primary alcohol is prone to oxidation and oxidized into an aldehyde, and the aldehyde reacts with the amine as the protective agent for the silver nanoparticles to form an imine, thus reducing the amine as the protective agent and in turn reducing the dispersibility of the silver nanoparticles. Thus, the amount of the primary alcohol exceeding the above range would cause difficulty in maintaining the dispersibility of the ink stably for a long period of time, and thus this is not preferred.

The inkjet printing ink according to an embodiment of the present invention can contain, in addition to the surface-modified silver nano-particles (A) and the dispersion solvent (B), an additive, such as, for example, a dispersant, a surface energy modifier, a plasticizer, a leveling agent, an antifoaming agent, or a tackifier (e.g., a terpene-based resin, a rosin-based resin, a petroleum resin, or a rubber-like elastic body) as necessary.

### Method for producing ink

The ink according to an embodiment of the present invention can be produced, for example, through: mixing a silver compound and a protective agent containing an amine to form a complex containing the silver compound and the amine (formation of the complex); thermally decomposing the complex (thermal decomposition); and producing surface-modified silver nanoparticles (A) through, as necessary, washing the reaction product (washing), and mixing the resulting surface-modified silver nanoparticles (A) and the dispersion solvent (B) (preparation of the ink).

### Formation of complex

The formation of the complex is to mix a silver compound and a protective agent containing an amine and to form a complex containing the silver compound and the amine. The silver compound used is preferably a compound easily decomposed by heating to form metallic silver. Examples of such a silver compound include silver carboxylates, such as silver formate, silver acetate, silver oxalate, silver malonate, silver benzoate, and silver phthalate; silver halides, such as silver fluoride, silver chloride, silver bromide, and silver iodide; and silver sulfate, silver nitrate, and silver carbonate. In an embodiment of the present invention, among them, silver oxalate is preferred in that it has a high silver content, can be thermally decomposed without a reducing agent, and thus an impurity derived from the reducing agent is less likely to be mixed into the ink.

The amine used as the protective agent is a compound in which at least one hydrogen atom of ammonia is substituted with a hydrocarbon group, and includes a primary amine, a secondary amine, and a tertiary amine. In addition, the amine may be a monoamine or a polyamine, such as a diamine. One of these amines can be used alone, or two or more of them in combination.

The amine preferably contains at least one selected from a monoamine (1) having 6 or more carbon atoms in total and represented by Formula (a-1) below, where R¹, R², and R³ are identical or different and are hydrogen atoms or monovalent hydrocarbon groups (with the provisio that the canse in which R¹, R², and R³ are all hydrogen atoms is omitted); monoamine (2) having 5 or less carbon atoms in total and represented by Formula (a-1) below, where R¹, R², and R³ are identical or different and are hydrogen atoms or monovalent hydrocarbon groups (with the provisio that the canse in which R¹, R², and R³ are all hydrogen atoms is omitted); and a diamine (3) having 8 or less carbon atoms in total and represented by Formula (a-2), where R⁴ to R⁷ are identical or different and are hydrogen atoms or monovalent hydrocarbon groups, and R⁸ is a divalent hydrocarbon group; and in particular, preferably contains the monoamine (1) in combination with the monoamine (2) and/or the diamine (3).

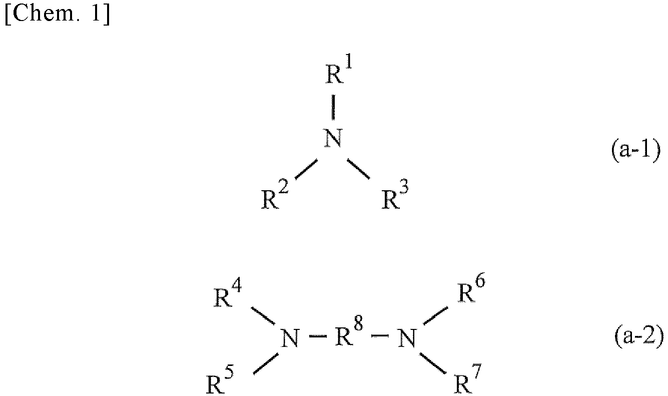

The hydrocarbon group includes an aliphatic hydrocarbon group, an alicyclic hydrocarbon group, and an aromatic hydrocarbon group, and among them, an aliphatic hydrocarbon group or an alicyclic hydrocarbon group is preferred, and in particular, an aliphatic hydrocarbon group is preferred. Thus, the monoamine (1), the monoamine (2), and the diamine (3) are preferably an aliphatic monoamine (1), an aliphatic monoamine (2), and an aliphatic diamine (3).

In addition, the monovalent aliphatic hydrocarbon group includes an alkyl group and an alkenyl group. The monovalent alicyclic hydrocarbon group includes a cycloalkyl group and a cycloalkenyl group. Furthermore, the divalent aliphatic hydrocarbon group includes an alkylene group and an alkenylene group, and the divalent alicyclic hydrocarbon group includes a cycloalkylene group and a cycloalkenylene group.

Examples of the monovalent hydrocarbon group in R¹, R², and R³ may include alkyl groups having approximately from 1 to 20 carbon atoms, such as a methyl group, an ethyl group, a propyl group, an isopropyl group, a butyl group, an isobutyl group, an s-butyl group, a t-butyl group, a pentyl group, a hexyl group, a decyl group, a dodecyl group, a tetradecyl group, an octadecyl group; alkenyl groups having approximately from 2 to 20 carbon atoms, such as a vinyl group, an allyl group, a methallyl group, a 1-propenyl group, an isopropenyl group, a 1-butenyl group, a 2-butenyl group, a 3-butenyl group, a 1-pentenyl group, a 2-pentenyl group, a 3-pentenyl group, a 4-pentenyl group, and a 5-hexenyl group; cycloalkyl groups having approximately from 3 to 20 carbon atoms, such as a cyclopropyl group, a cyclobutyl group, a cyclopentyl group, a cyclohexyl group, and a cyclooctyl group; and cycloalkenyl groups having approximately from 3 to 20 carbon atoms, such as a cyclopentenyl group and a cyclohexenyl group.

Examples of the monovalent hydrocarbon groups in R⁴ to R⁷ may include, among those exemplified above, alkyl groups having from approximately 1 to 7 carbon atoms, alkenyl groups having approximately from 2 to 7 carbon atoms, cycloalkyl groups having approximately from 3 to 7 carbon atoms, and cycloalkenyl groups having approximately from 3 to 7 carbon atoms.

Examples of the divalent hydrocarbon group in R⁸ may include alkylene groups having from 1 to 8 carbon atoms, such as a methylene group, a methylmethylene group, a dimethylmethylene group, an ethylene group, a propylene group, a trimethylene group, a tetramethylene group, a pentamethylene group, and a heptamethylene group; and alkenylene groups having from 2 to 8 carbon atoms, such as a vinylene group, a propenylene group, a 1-butenylene group, a 2-butenylene group, a butadienylene group, a pentenylene group, a hexenylene group, a heptenylene group, and an octenylene group.

The hydrocarbon groups in the above R¹ to R⁸ may have a substituent of various types [e.g., such as a halogen atom, an oxo group, a hydroxyl group, a substituted oxy group (e.g., such as a C₁₋₄ alkoxy group, a C₆₋₁₀ aryloxy group, a C₇₋₁₆ aralkyloxy group, or a C₁₋₄ acyloxy group), a carboxyl group, a substituted oxycarbonyl group (e.g., such as a C₁₋₄ alkoxycarbonyl group, a C₆₋₁₀ aryloxycarbonyl group, or a C₇₋₁₆ aralkyloxycarbonyl group), a cyano group, a nitro group, a sulfo group, or a heterocyclic group]. In addition, the hydroxyl group and the carboxyl group may be protected with a protecting group commonly used in the field of organic synthesis.

The monoamine (1) is a compound that is adsorbed on the surfaces of the silver nanoparticles and prevents agglomeration of the silver nanoparticles and enlargement of the agglomeration, that is, a compound having a function of imparting high dispersibility to the silver nanoparticles. Examples of the monoamine (1) include primary monoamines having a linear alkyl group, such as n-hexylamine, n-heptylamine, n-octylamine, n-nonylamine, n-decylamine, n-undecylamine, and n-dodecylamine; primary amines having a branched alkyl group, such as isohexylamine, 2-ethylhexylamine, and tert-octylamine; a primary amine having a cycloalkyl group, such as cyclohexylamine; a primary amine having an alkenyl group, such as oleylamine; secondary amines having a linear alkyl group, such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, and N-propyl-N-butylamine; secondary amines having a branched alkyl group, such as N,N-diisohexylamine and N,N-di(2-ethylhexyl)amine; tertiary amines having a linear alkyl group, such as tributylamine and trihexylamine; and tertiary amines having a branched alkyl group, such as triisohexylamine and tri(2-ethylhexyl)amine.

Among the above monoamines (1), an amine (in particular, a primary amine) having a linear alkyl group having from 6 to 18 carbon atoms in total (more preferably up to 16 and particularly preferably up to 12 carbon atoms in total) is preferred in that such an amine can provide space between the silver nanoparticles when the amino groups is adsorbed on the silver nanoparticle surfaces, thus providing the effect of preventing agglomeration of the silver nanoparticles, and such an amine can be easily removed during sintering. In particular, n-hexylamine, n-heptylamine, n-octylamine, n-nonylamine, n-decylamine, n-undecylamine, n-dodedeyclamine, and the like are preferred.

The monoamine (2) has a shorter hydrocarbon chain than that of the monoamine (1), and thus the function of the monoamine (2) itself to impart high dispersibility to the silver nanoparticles is low. However, the monoamine (2) has a high coordination ability to a silver atom due to its higher polarity than that of the monoamine (1), and thus has an effect of promoting complex formation. In addition, the monoamine (2) has a short hydrocarbon chain and thus can be removed from the silver nanoparticle surfaces in a short time (e.g., not longer than 30 minutes and preferably not longer than 20 minutes) even in low-temperature sintering, thus providing a sintered body with excellent conductivity.

Examples of the monoamine (2) may include primary amines having a linear or branched alkyl group and having from 2 to 5 carbon atoms in total, such as ethylamine, n-propylamine, isopropylamine, n-butylamine, isobutylamine, sec-butylamine, tert-butylamine, pentylamine, isopentylamine, and tert-pentylamine; and secondary amines having a linear or branched alkyl group and having from 2 to 5 carbon atoms in total, such as N,N-dimethylamine, N,N-diethylamine, N-methyl-N-propylamine, and N-ethyl-N-propylamine.

The monoamine (2) is, among them, preferably a primary amine having a linear or branched alkyl group and having from 2 to 5 carbon atoms in total (preferably from 4 to 5 carbon atoms in total), such as n-butylamine, isobutylamine, sec-butylamine, tert-butylamine, pentylamine, isopentylamine, and tert-pentylamine, and in particular, preferably a primary amine having a linear alkyl group and having from 2 to 5 carbon atoms in total (preferably from 4 to 5 carbon atoms in total), such as n-butylamine.

The diamine (3) has 8 or less (e.g., from 1 to 8) carbon atoms in total and has a high coordination ability to a silver atom due to its higher polarity than that of the monoamine (1), and thus has an effect of promoting complex formation. In addition, the diamine (3) has an effect of promoting thermal decomposition of the complex at lower temperature and in a short time in the thermal decomposition of the complex, and the use of the diamine (3) can perform the production of the surface-modified silver nanoparticles more efficiently. Furthermore, the configuration in which the surface-modified silver nanoparticles are coated with a protective agent containing the diamine (3) exhibit excellent dispersion stability in a highly polar dispersion solvent. Moreover, the diamine (3) has a short hydrocarbon chain and thus can be removed from the silver nanoparticle surfaces in a short time (e.g., not longer than 30 minutes and preferably not longer than 20 minutes) even by low-temperature sintering, thus providing a sintered body with excellent conductivity.

Examples of the diamine (3) may include diamines in which R⁴ to R⁷ in Formula (a-2) are hydrogen atoms, and R⁸ is a linear or branched alkylene group, such as ethylenediamine, 1,3-propanediamine, 2,2-dimethyl-1,3-propanediamine, 1,4-butanediamine, 1,5-pentanediamine, 1,6-hexanediamine, 1,7-heptanediamine, 1,8-octanediamine, and 1,5-diamino-2-methylpentane; diamines in which R⁴ and R⁶ in Formula (a-2) are identical or different and linear or branched alkyl groups, R⁵ and R⁷ are hydrogen atoms, and R⁸ is a linear or branched alkylene group, such as N,N' -dimethylethylenediamine, N,N'-diethylethylenediamine, N,N'-dimethyl-1,3-propanediamine, N,N'-diethyl-1,3-propanediamine, N,N'-dimethyl-1,4-butanediamine, N,N'-diethyl-1,4-butanediamine, and N,N'-dimethyl-1,6-hexanediamine; and diamines in which R⁴ and R⁵ in Formula (a-2) are identical or different and linear or branched alkyl groups, R⁶ and R⁷ are hydrogen atoms, and R⁸ is a linear or branched alkylene group, such as N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, and N,N-dimethyl-1,6-hexanediamine.

Among them, diamines in which R⁴ and R⁵ in Formula (a-2) above are identical or different and linear or branched alkyl groups, R⁶ and R⁷ are hydrogen atoms, and R⁸ is a linear or branched alkylene group [in particular, diamines in which R⁴ and R⁵ in Formula (a-2) are linear alkyl groups, R⁶ and R⁷ are hydrogen atoms, and R⁸ is a linear alkylene group] are preferred.

In diamines in which R⁴ and R⁵ in Formula (a-2) are identical or different and are linear or branched alkyl groups, and R⁶ and R⁷ are hydrogen atoms, that is, diamines having a primary amino group and a tertiary amino group, the primary amino group has a high coordination ability to a silver atom, but the tertiary amino group has a poor coordination ability to a silver atom, and thus this prevents a resulting complex from becoming excessively complicated, thereby allowing the complex to be thermally decomposed at lower temperature and in a shorter time in the thermal decomposition of the complex. Among them, diamines having 6 or less (e.g., from 1 to 6) carbon atoms in total are preferred, and diamines having 5 or less (e.g., from 1 to 5) carbon atoms in total are more preferred in that they can be removed from the silver nanoparticle surfaces in a short time in low-temperature sintering.

In the amine in an embodiment of the present invention containing the monoamine (1) in combination with the monoamine (2) and/or the diamine (3), the proportion of these amines used is not particularly limited but is preferably in the range described below on the basis of the total amount of the amines [monoamine (1) + monoamine (2) + diamine (3); 100 mol%].

Content of monoamine (1): for example, from 5 to 65 mol% (the lower limit is preferably 10 mol%, particularly preferably 20 mol%, and most preferably 30 mol%. In addition, the upper limit is preferably 60 mol%, and particularly preferably 50 mol%)

Total content of monoamine (2) and diamine (3): for example, from 35 to 95 mol% (the lower limit is preferably 40 mol%, and particularly preferably 50 mol%. In addition, the upper limit is preferably 90 mol%, particularly preferably 80 mol%, and most preferably 70 mol%)

Furthermore, when using the monoamine (1), the monoamine (2), and the diamine (3) together, each content of the monoamine (2) and the diamine (3) is preferably in the range described below on the basis of the total amount of the amines [monoamine (1) + monoamine (2) + diamine (3); 100 mol%].

Monoamine (2): for example, from 5 to 65 mol% (The lower limit is preferably 10 mol%, particularly preferably 20 mol%, and most preferably 30 mol%. In addition, the upper limit is preferably 60 mol%, and particularly preferably 50 mol%)

Diamine (3): for example, from 5 to 50 mol% (The lower limit is preferably 10 mol%. In addition, the upper limit is preferably 40 mol%, and particularly preferably 30 mol%)

The monoamine (1) contained in the above range provides dispersion stability of the silver nanoparticles. With the amount of the monoamine (1) below the above range, the silver nanoparticles would tend to be prone to agglomeration. On the other hand, the amount of the monoamine (1) exceeding the above range would cause difficulty in removing the amines from the silver nanoparticle surfaces in a short time when the sintering temperature is low, tending to reduce the conductivity of the resulting sintered body.

The monoamine (2) contained in the above range provides the effect of promoting complex formation. In addition, this allows the amine to be removed from the silver nanoparticle surfaces in a short time even when the sintering temperature is low, providing a sintered body with excellent conductivity.

The diamine (3) contained in the above range easily provides the effect of promoting complex formation and the effect of promoting the thermal decomposition of the complex. In addition, the surface-modified silver nanoparticles having a configuration coated with a protective agent containing the diamine (3) exhibit excellent dispersion stability in a highly polar dispersion solvent.

In an embodiment of the present invention, the use of the monoamine (2) and/or the diamine (3) having a high coordination ability to a silver atom can reduce the amount of the monoamine (1) used depending on the proportion of the monoamine (2) and/or the diamine (3) used and can remove the amines from the silver nanoparticle surfaces in a short time even when the sintering temperature is low, providing a sintered body with excellent conductivity.

The amine used as the protective agent in an embodiment of the present invention may contain an additional amine other than the monoamine (1), the monoamine (2), and the diamine (3), but the proportion of the total amount of the monoamine (1) and the monoamine (2), and the diamine (3) accounting for the total amines contained in the protective agent is, for example, preferably from 60 to 100 wt.%, and the lower limit is particularly preferably 80 wt.% and most preferably 90 wt.%. That is, the amount of the additional amine is preferably not greater than 40 wt.%, particularly preferably not greater than 20 wt.%, and most preferably not greater than 10 wt.%.

The amount of the amine [in particular, monoamine (1) + monoamine (2) + diamine (3)] used is not particularly limited but is preferably approximately from 1 to 50 mol, particularly preferably from 2 to 50 mol, and most preferably from 6 to 50 mol, relative to 1 mol of silver atoms in the silver compound of the raw material. When the amount of the amine is below the above range, the silver compound not converted to a complex would be prone to remain in the formation of the complex, tending to be difficult to impart sufficient dispersibility to the silver nanoparticles.

In an embodiment of the present invention, to further improve the dispersibility of the silver nanoparticles, one or two or more aliphatic monocarboxylic acids may be used as the protective agent.

Examples of the aliphatic monocarboxylic acid may include saturated aliphatic monocarboxylic acids having 4 or more carbon atoms, such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, and icosanoic acid; and unsaturated aliphatic monocarboxylic acids having 8 or more carbon atoms, such as oleic acid, elaidic acid, linoleic acid, palmitoleic acid, and eicosenoic acid.

Among them, saturated or unsaturated aliphatic monocarboxylic acids having from 8 to 18 carbon atoms (in particular, octanoic acid and oleic acid) are preferred. When the carboxyl groups of the aliphatic monocarboxylic acid is adsorbed on the silver nanoparticle surfaces, the saturated or unsaturated aliphatic hydrocarbon chain having from 8 to 18 carbon atoms causes a steric hindrance and thus can provide space between the silver nanoparticles, thus improving the effect of preventing agglomeration of the silver nanoparticles.

The amount of the aliphatic monocarboxylic acid used is, for example, approximately from 0.05 to 10 mol, preferably from 0.1 to 5 mol, and particularly preferably from 0.5 to 2 mol, relative to 1 mol of silver atoms in the silver compound. The amount of the aliphatic monocarboxylic acid used below the above range would cause difficulty in providing an effect of improving stability. On the other hand, the aliphatic monocarboxylic acid even used in an excessive amount would saturate the effect of improving the dispersion stability while it tends to be difficult to remove the aliphatic monocarboxylic acid by low-temperature sintering.

The reaction between the protective agent containing an amine and the silver compound is performed in the presence or absence of the dispersion solvent. As the dispersion solvent, for example, an alcohol having 3 or more carbon atoms can be used.

Examples of the alcohol having 3 or more carbon atoms include n-propanol (boiling point: 97°C), isopropanol (boiling point: 82°C), n-butanol (boiling point: 117°C), isobutanol (boiling point: 107.89°C), sec-butanol (boiling point: 99.5°C), tert-butanol (boiling point: 82.45°C), n-pentanol (boiling point: 136°C), n-hexanol (boiling point: 156°C), n-octanol (boiling point: 194°C), and 2-octanol (boiling point: 174°C). Among them, alcohols having from 4 to 6 carbon atoms are preferred, and in particular, n-butanol and n-hexanol are preferred in that higher temperature can be set for the thermal decomposition of the complex to be performed later and in terms of the convenience of the post-treatment of the resulting surface-modified silver nanoparticles.

In addition, the amount of the dispersion solvent used is, for example, not less than 120 parts by weight, preferably not less than 130 parts by weight, and more preferably not less than 150 parts by weight, relative to 100 parts by weight of the silver compound. The upper limit of the amount of the dispersion solvent used is, for example, 1000 parts by weight, preferably 800 parts by weight, and particularly preferably 500 parts by weight.

The reaction between the protective agent containing an amine and the silver compound is preferably performed at ordinary temperature (from 5 to 40°C). The reaction is accompanied by heat generation due to the coordination reaction of the amine to the silver compound and thus may be performed while the reaction mixture is appropriately cooled to the above temperature range.

The reaction time between the protective agent containing an amine and the silver compound is, for example, approximately from 30 minutes to 3 hours. This provides a silver-amine complex.

### Thermal decomposition

The thermal decomposition is to thermally decompose the silver-amine complex (i.e., a silver compound coordinated with the amine) obtained through the formation of the complex and to form the surface-modified silver nanoparticles, and the following reaction is considered to proceed.

That is, heating the silver-amine complex allows the silver compound to be thermally decomposed in a state of being coordinated with the amine. This provides silver atoms coordinated with the amines. The silver atoms coordinated with the amines then agglomerate to form silver nanoparticles coated with an amine protective film, i.e., the surface-modified silver nanoparticles.

The thermal decomposition is preferably performed in the presence of a dispersion solvent, and the alcohol described above can be suitably used as the dispersion solvent. In addition, the thermal decomposition temperature is to be a temperature at which the surface-modified silver nanoparticles are formed, and when the silver-amine complex is a silver oxalate-amine complex, the temperature is, for example, approximately from 80 to 120°C, preferably from 95 to 115°C, and particularly preferably from 100 to 110°C. In terms of preventing the elimination of the surface modification portion of the surface-modified silver nanoparticle, the thermal decomposition is preferably performed at a temperature as low as possible within the above temperature range. The thermal decomposition duration is, for example, approximately from 10 minutes to 5 hours.

In addition, the thermal decomposition of the silver-amine complex is preferably performed in an air atmosphere or in an inert gas atmosphere, such as argon.

### Washing

The excess protective agent (e.g., amine), if present after the completion of the thermal decomposition reaction of the silver-amine complex, is preferably removed by decantation, which may be repeated two or more times as necessary.

Decantation is performed, for example, by washing the surface-modified silver nanoparticles in a suspended state with a cleaning agent, precipitating the surface-modified silver nanoparticles by centrifugation, and removing the supernatant. The cleaning agent used is preferably one or two or more of linear or branched alcohols having from 1 to 4 (preferably from 1 to 2) carbon atoms, such as methanol, ethanol, n-propanol, or isopropanol in terms of achieving good precipitation of the surface-modified silver nanoparticles and efficiently separating and removing the cleaning agent by centrifugation after the washing. In addition, the surface-modified silver nanoparticles after the completion of the decantation is preferably subjected to the preparation of the ink described below in a wet state without drying or solidifying in that this can prevent re-agglomeration of the surface-modified silver nanoparticles and maintain high dispersibility.

### Preparation of ink

The preparation of the ink is to mix the surface-modified silver nanoparticle (A) (preferably the surface-modified silver nanoparticles (A) in a wet state) obtained through the above processes and the dispersion solvent (B), and an additive as necessary and to obtain the ink according to an embodiment of the present invention. For the mixing, a commonly known mixing apparatus, such as, for example, a self-rotating stirring defoaming apparatus, a homogenizer, a planetary mixer, a three-roll mill, or a bead mill, can be used. In addition, each component may be mixed at the same time or sequentially.

The mixing portion of each component can be appropriately adjusted in a range where the ink with the composition described below is obtained.

The amount of the surface-modified silver nanoparticles (A) (in terms of silver) in the total amount of the ink (100 wt.%) according to an embodiment of the present invention is not less than 30 wt.%, and for example, preferably approximately from 30 to 70 wt.%. The lower limit is particularly preferably 35 wt.% in terms of obtaining a coating film or sintered body with higher film thickness. The upper limit is more preferably 65 wt.% and particularly preferably 60 wt.% in terms of stability of ejection from the inkjet head nozzle.

The ratio of the amount of the surface-modified silver nanoparticles (A) to the total amount of the surface-modified silver nanoparticles (A) and the dispersion solvent (B) [(A)/((A) + (B))] is not less than 30 wt.% and, for example, preferably approximately from 30 to 70 wt.%. The lower limit is particularly preferably 35 wt.% in terms of obtaining a coating film or sintered body with higher film thickness. The upper limit is more preferably 65 wt.% and particularly preferably 60 wt.% in terms of stability of ejection from the inkjet head nozzle.

When the ink according to an embodiment of the present invention is the high concentration ink, the amount of the surface-modified silver nano-particles (A) (in terms of silver) is, for example, from 70 to 230 parts by weight and preferably from 100 to 150 parts by weight, relative to 100 parts by weight of the dispersion solvent (B).

When the ink according to an embodiment of the present invention is the high concentration ink, the ratio [(A)/((A) + (B))] is, for example, greater than 40 wt.% and not greater than 70 wt.%. The lower limit is preferably 42 wt.%, particularly preferably 45 wt.%, and most preferably 50 wt.% in terms of obtaining a coating film or sintered body with higher film thickness. The upper limit is more preferably 65 wt.% in terms of stability of ejection from the nozzle of the inkjet head.

When the ink according to an embodiment of the present invention is the medium concentration ink, the amount of the surface-modified silver nano-particles (A) (in terms of silver) is, for example, from 43 to 67 parts by weight and preferably from 50 to 65 parts by weight, relative to 100 parts by weight of the dispersion solvent (B).

When the ink according to an embodiment of the present invention is the medium concentration ink, the ratio [(A)/((A) + (B))] is, for example, from 30 to 40 wt.%. The lower limit is preferably 35 wt.% in terms of obtaining a coating film or sintered body with higher film thickness.

The amount of the dispersion solvent (B) in the total amount of the ink (100 wt.%) according to an embodiment of the present invention is, for example, not greater than 70 wt.% and preferably not greater than 65 wt.%. The upper limit is, for example, 30 wt.% and preferably 40 wt.%. The ink according to an embodiment of the present invention containing the dispersion solvent (B) in the above range can well maintain stability of ejection from the nozzle of the inkjet head.

The ink according to an embodiment of the present invention contains, as the dispersion solvent (B), the (b-1), and the (b-2). The total amount of the (b-1) and the (b-2) is not less than 70 wt.%, preferably 75 wt.% or higher, particularly preferably 80 wt.% or higher, and most preferably 85 wt.% or higher of the total amount of the dispersion solvent (B) (i.e., the total amount of the dispersion media contained in the ink according to an embodiment of the present invention; 100 wt.%).

The amount of the (b-1) (the total amount when two or more alcohols are contained) in the total amount of the dispersion solvent (B) contained in the ink according to an embodiment of the present invention is, for example, from 50 to 85 wt.%, preferably from 55 to 80 wt.%, particularly preferably from 60 to 75 wt.%, and most preferably from 60 to 70 wt.%.

The amount of the (b-2) (the total content when two or more hydrocarbons are contained) in the total amount of the dispersion media (B) contained in the ink according to an embodiment of the present invention is, for example, from 5 to 45 wt.%, preferably from 10 to 40 wt.%, particularly preferably from 15 to 30 wt.%, and most preferably from 15 to 25 wt.%.

Furthermore, the amount of the primary alcohol in the total amount of the dispersion solvent (B) contained in the ink according to an embodiment of the present invention (or the total amount of the (b-1) and the (b-2)) is not greater than 30 wt.%, preferably not greater than 25 wt.%, even more preferably not greater than 20 wt.%, still more preferably not greater than 15 wt.%, further not greater than 10 wt.%, particularly preferably not greater than 5 wt.%, and most preferably not greater than 3 wt.%.

Still further, the amount of the primary alcohol in the ink according to an embodiment of the present invention is, for example, not greater than 50 parts by weight, preferably not greater than 30 parts by weight, more preferably not greater than 25 parts by weight, even more preferably not greater than 20 parts by weight, still more preferably not greater than 15 parts by weight, further not greater than 10 parts by weight, particularly preferably not greater than 5 parts by weight, and most preferably not greater than 3 parts by weight, relative to 100 parts by weight of the surface-modified silver nanoparticles (A).

In addition, the proportion of the total amount of the surface-modified silver nano-particles (A) and the dispersion solvent (B) accounting for the total amount of the ink (100 wt.%) according to an embodiment of the present invention is, for example, not less than 70 wt.%, preferably not less than 80 wt.%, and particularly preferably not less than 90 wt.%.

In addition, the proportion of the total amount of the surface-modified silver nanoparticles (A), the (b-1), and the (b-2) accounting for the total amount of the ink (100 wt.%) according to an embodiment of the present invention is, for example, not less than 70 wt.%, preferably not less than 80 wt.%, and particularly preferably not less than 90 wt.%.

The viscosity of the ink according to an embodiment of the present invention varies with the amount of the surface-modified silver nanoparticles (A) in the ink. When the ink according to an embodiment of the present invention is the medium concentration ink, the viscosity (at 25°C and a shear rate of 10 (1/s)) is, for example, not greater than 20 mPa•s (e.g., from 2 to 20 mPa•s), preferably from 3 to 15 mPa•s, and particularly preferably from 5 to 15 mPa•s. The viscosity (mPa•s) of the ink can be measured using a falling-ball viscometer (e.g., Lovis 2000M) or a rotational viscometer (e.g., Model BM).

The ink according to an embodiment of the present invention contains the dispersion solvent (B) described above and thus can prevent the increase in imine content over time to an extremely low level. That is, this prevents the decrease of the amine constituting the surface modification portion of the surface-modified silver nanoparticles (A) over time to an extremely low level. Thus, the ink according to an embodiment of the present invention has excellent dispersion stability.

In addition, the ink according to an embodiment of the present invention contains the dispersion solvent (B) described above, thus has excellent dispersion stability of the surface-modified silver nanoparticles (A) and can maintain good ejection properties stably over a long period of time. Furthermore, the ink according to an embodiment of the present invention has excellent low-temperature sintering properties and provides a sintered body with excellent conductivity by low-temperature sintering. Thus, the ink according to an embodiment of the present invention can be suitably used for inkjet printing.

### Method for producing electronic device

A method for producing an electronic device according to an embodiment of the present invention includes coating the ink according to an embodiment of the present invention onto a substrate by an inkjet printing method, and sintering. This provides an electronic device including a sintered body of the ink according to an embodiment of the present invention (preferably an electronic component, such as a circuit, wiring, and an electrode, including a sintered body of the ink according to an embodiment of the present invention).

The method for producing an electronic device according to an embodiment of the present invention uses the ink according to an embodiment of the present invention and thus enables sintering at low temperature, and the sintering temperature is, for example, not higher than 150°C, particularly preferably not higher than 130°C, and most preferably not higher than 120°C. The lower limit of the sintering temperature is approximately 60°C, and preferably 100°C in terms of enabling sintering in a short time. The sintering time is, for example, from 0.5 to 3 hours, preferably from 0.5 to 2 hours, and particularly preferably from 0.5 to 1 hour.

Using the ink according to an embodiment of the present invention allows sintering of the silver nanoparticles to sufficiently proceed even by low-temperature sintering (e.g., even by sintering at low temperature and in a short time, such as 120°C for 30 minutes). As a result, a sintered body with excellent conductivity is obtained. The conductivity (or volume resistivity) of the sintered body can be measured by the method described in Examples.

The conductivity of the sintered body of the ink according to an embodiment of the present invention varies with the amount of the surface-modified silver nanoparticles (A) in the ink.

For example, when the ink according to an embodiment of the present invention is the medium concentration ink, the volume resistivity of the resulting sintered body is, for example, not greater than 15 µΩcm, preferably not greater than 13 µΩcm, more preferably not greater than 12 µΩcm, and even more preferably not greater than 10 µΩcm.

For example, when the ink according to an embodiment of the present invention is the high concentration ink, the volume resistivity of the resulting sintered body is, for example, not greater than 10 µΩcm and preferably not greater than 9 µΩcm.

Using the ink according to an embodiment of the present invention enables low-temperature sintering as described above, and thus in addition to a glass substrate and a heat-resistant plastic substrate, such as a polyimide-based film; a commodity plastic substrate with low heat-resistant can also be suitably used, including a polyester-based film, such as a polyethylene terephthalate (PET) film or a polyethylene naphthalate (PEN) film; or a poly olefin-based film, such as polypropylene.

Electronic devices obtained by the method for producing an electronic device according to an embodiment of the present invention include, for example, liquid crystal displays, organic EL displays, field emission displays (FED), IC cards, IC tags, solar cells, LED elements, organic transistors, condensers (capacitors), electronic paper, flexible batteries, flexible sensors, membrane switches, touch panels, and EMI shields.

### Examples

Hereinafter, the present invention will be described more specifically with reference to examples, but the present invention is not limited by these examples.

Dispersion media used in Examples and Comparative Examples are as follows.

### Secondary alcohol

DL-menthol, a boiling point of 212°C, a reagent available from Tokyo Chemical Industry Co., Ltd.

3,3,5-Trimethylcyclohexanol, a boiling point of 196.5°C, a reagent available from Tokyo Chemical Industry Co., Ltd.

3,5-Dimethylcyclohexanol, a boiling point of 185°C, a reagent available from Tokyo Chemical Industry Co., Ltd.

1-Cyclohexylethanol, a boiling point of 189°C, a reagent available from Tokyo Chemical Industry Co., Ltd.

2-Ethylcyclohexanol, a boiling point of 79°C, a reagent available from Tokyo Chemical Industry Co., Ltd.

### Tertiary alcohol

1-Methylcyclohexanol, a boiling point of 168°C, a reagent available from Tokyo Chemical Industry Co., Ltd.

### Primary alcohol

Cyclohexanemethanol, a boiling point of 181°C, a reagent available from Tokyo Chemical Industry Co., Ltd.

Cyclohexaneethanol, a boiling point of 206 to 207°C, a reagent available from Tokyo Chemical Industry Co., Ltd.

### Hydrocarbon

n-Hexadecane, a boiling point of 287°C, a reagent available from Tokyo Chemical Industry Co., Ltd.

n-Pentadecane, a boiling point of 271°C, a reagent available from Tokyo Chemical Industry Co., Ltd.

### Preparative Example 1 (Preparation of surface-modified silver nanoparticles) Formation of complex

Silver oxalate (molecular weight: 303.78) was obtained from silver nitrate (available from Wako Pure Chemical Industries, Ltd.) and oxalic acid dihydrate (available from Wako Pure Chemical Industries, Ltd.).

Then, 20.0 g (65.8 mmol) of the silver oxalate was charged to a 500-mL flask, 30.0 g of n-butanol was added to this, and a slurry containing silver oxalate and n-butanol was prepared.

To this slurry, an amine mixture liquid of 57.8 g (790.1 mmol) of n-butylamine (a molecular weight of 73.14, available from Daicel Corporation), 40.0 g (395.0 mmol) of n-hexylamine (a molecular weight of 101.19, available from Tokyo Chemical Industry Co., Ltd.), 38.3 g (296.3 mmol) of n-octylamine (a molecular weight of 129.25, trade designation "FARMIN 08D", available from Kao Corporation), 18.3 g (98.8 mmol) of n-dodecylamine (a molecular weight of 185.35, trade designation "FARMIN 20D", available from Kao Corporation), and 40.4 g (395.0 mmol) of N,N-dimethyl-1,3-propanediamine (a molecular weight of 102.18, available from Koei Chemical Co., Ltd.) was added dropwise at 30°C.

After the dropwise addition, the mixture was stirred at 30°C for 2 hours to allow a complex forming reaction between silver oxalate and the amines to proceeded, and a white material (silver oxalate-amine complex) was obtained.

### Thermal decomposition

After the formation of the silver oxalate-amine complex, the reaction solution temperature was raised from 30°C to approximately 105°C (specifically, from 103 to 108°C), then the silver oxalate-amine complex was thermally decomposed by heating for 1 hour in a state of maintaining the temperature, and a dark blue suspension in which surface-modified silver nanoparticles were suspended in the amine mixture liquid was obtained.

### Washing

After cooling, 200 g of methanol was added to the resulting suspension, and the mixture was stirred. Then, the surface-modified silver nanoparticles were precipitated by centrifugation, and the supernatant was removed. Then, 60 g of methanol was added again, and the mixture was stirred, then the surface-modified silver nanoparticles were precipitated by centrifugation, and the supernatant was removed. Surface-modified silver nanoparticles in a wet state were thus obtained.

### Example 1

To the surface-modified silver nanoparticles in a wet state obtained in Preparative Example 1, DL-menthol/n-hexadecane (75/25 (weight ratio)) was added as a dispersion solvent to make the silver concentration 37 wt.%, the mixture was stirred, and an ink (1) was obtained.

### Conductivity test

The ink (1) was coated onto an alkali-free glass plate by a spin coating method to form a coating film. The coating film formed was rapidly sintered using a hot plate at 120°C for 30 minutes, and a sintered body with a thickness of 1.0 µm was obtained. The resulting sintered body, as measured by a four-terminal method for volume resistivity, exhibited good conductivity of 11.4 µΩcm.

### Filtration test

Furthermore, when the ink (1) immediately after obtained was subjected to a filtration test using a syringe filter (pore diameter: 0.2 µm), not less than 15 mL of the ink was filtered.

When the ink (1) was stored at 5°C for 23 days and then filtered in a similar manner, not less than 15 mL of the ink was filterable, exhibiting good dispersion stability.

Still further, 20 mL of the ink (1) was placed in a flask and stirred at 50°C for 9 hours to perform an accelerated test for dispersion stability. When the amine concentration in the ink (1) before and after the accelerated test each was analyzed, dodecylamine before the test was 33 mmol/kg, and dodecylamine after the test was 32 mmol/kg, revealing no change in the dodecylamine concentration before and after testing. In addition, when the ink (1) after the accelerated test was subjected to GC/MS analysis, imine was not observed.

### Example 2

An ink (2) was obtained in the same manner as in Example 1 except that 3,3,5-trimethylcyclohexanol/n-pentadecane (75/25 (weight ratio)) was used as the dispersion solvent.

A sintered body with a thickness of 1.0 µm was obtained in the same manner as in Example 1 except that the ink (2) was used in place of the ink (1). The volume resistivity of the resulting sintered body was 9.6 µΩcm, indicating good conductivity.

In addition, when the ink (2) immediately after obtained was subjected to a filtration test similar to that of Example 1, not less than 15 mL of the ink was filterable.

Furthermore, when the ink (2) was stored at 5°C for 21 days and then filtered in a similar manner, not less than 15 mL of the ink was filterable, exhibiting good dispersion stability.

### Example 3

An ink (3) was obtained in the same manner as in Example 1 except that the dispersion solvent was changed to 3,5-dimethylcyclohexanol/n-pentadecane (75/25 (weight ratio)).

A sintered body with a thickness of 1.0 µm was obtained in the same manner as in Example 1 except that the ink (3) was used in place of the ink (1). The volume resistivity of the resulting sintered body was 14.6 µΩcm, indicating good conductivity.

In addition, when the ink (3) immediately after obtained was subjected to a filtration test similar to that of Example 1, not less than 15 mL of the ink was filterable.

Furthermore, when the ink (3) was stored at 5°C for 23 days and then filtered in a similar manner, not less than 15 mL of the ink was filterable, exhibiting good dispersion stability.

### Example 4

An ink (4) was obtained in the same manner as in Example 1 except that the dispersion solvent was changed to 1-cyclohexylethanol/n-pentadecane (75/25 (weight ratio)).

A sintered body with a thickness of 1.0 µm was obtained in the same manner as in Example 1 except that the ink (4) was used in place of the ink (1). The volume resistivity of the resulting sintered body was 7.2 µΩcm, indicating good conductivity.

In addition, when the ink (4) immediately after obtained was subjected to a filtration test similar to that of Example 1, not less than 15 mL of the ink was filterable.

Furthermore, when the ink (4) was stored at 5°C for 20 days and then filtered in a similar manner, not less than 15 mL of the ink was filterable, exhibiting good dispersion stability.

### Example 5

An ink (5) was obtained in the same manner as in Example 1 except that the dispersion solvent was changed to 2-ethylcyclohexanol/n-pentadecane (75/25 (weight ratio)).

A sintered body with a thickness of 1.0 µm was obtained in the same manner as in Example 1 except that the ink (5) was used in place of the ink (1). The volume resistivity of the resulting sintered body was 12.6 µΩcm, indicating good conductivity.

In addition, when the ink (5) immediately after obtained was subjected to a filtration test similar to that of Example 1, not less than 15 mL of the ink was filterable.

Furthermore, when the ink (5) was stored at 5°C for 25 days and then filtered in a similar manner, not less than 15 mL of the ink was filterable, exhibiting good dispersion stability.

### Example 6

An ink (6) was obtained in the same manner as in Example 1 except that the dispersion solvent was changed to 1-methylcyclohexanol/n-pentadecane (75/25 (weight ratio)).

When the ink (6) immediately after obtained was subjected to a filtration test similar to that of Example 1, 10 mL of the ink was filterable.

Furthermore, when the ink (6) was stored at 5°C for 20 days and then filtered in a similar manner, 10 mL of the ink was filterable, exhibiting good dispersion stability.

### Comparative Example 1

An ink (7) was obtained in the same manner as in Example 1 except that the dispersion solvent was changed to cyclohexanemethanol/n-pentadecane (75/25 (weight ratio)).

When the ink (7) immediately after obtained was subjected to a filtration test similar to that of Example 1, not less than 15 mL of the ink was filterable.

In addition, when the amine concentration in the ink (7) immediately after obtained was analyzed, dodecylamine was 21 mmol/kg, and imine was 2 mmol/kg.

When the ink (7) was stored at 5°C for 16 days and then filterable in a similar manner, only 5 mL of the ink was filterable.

When the amine concentration in the ink (7) after stored at 5°C for 16 days was analyzed, dodecylamine was 11 mol/kg, and imine was 10 mol/kg, revealing a decrease of dodecyl amine and an increase of imine compared with the initial values.

In addition, the ink (7) (containing 15 mmol/kg of dodecylamine and 7 mmol/kg of imine) was placed in a 50-mL flask and stirred at 50°C for 9 hours to perform an accelerated test for dispersion stability. When the amine concentration in the ink (7) after the accelerated test was analyzed, dodecylamine was 6 mmol/kg, and imine was 16 mmol/kg, revealing the decrease of dodecyl amine and the increase of imine compared with the values before the accelerated test.

### Example 7

An ink (8) was obtained in the same manner as in Example 1 except that the dispersion solvent was changed to 3,3,5-trimethylcyclohexanol/n-hexadecane (a weight ratio of 75/25), and the silver concentration was changed to 50 wt.%.

The surface-modified silver nanoparticles of the ink (8) had an average particle diameter of 25 nm as determined by dynamic light scattering using the analyzer trade designated "Zetananosizer Series Nano-S" (available from Malvern Panalytical Ltd.).

### Conductivity test

A sintered body with a thickness of 1.0 µm was obtained in the same manner as in Example 1 except that the ink (8) was used in place of the ink (1). The volume resistivity of the resulting sintered body was 6.8 µΩcm, indicating good conductivity.

### Ejection property test

In addition, the ink (8) was used for inkjet printing (trade name "Inkjet Head KM512-SHX", available from Konica Minolta, Inc.) to evaluate ejection properties.

The initial ejection properties were observed with a photograph capturing a state of the ejection of the ink from the inkjet head, the photograph taken from the lateral side. As a result, it was confirmed that ink droplets were well ejected from all nozzles.

For re-ejection after intermittent standing, ejection properties when the ejection was stopped for 5 minutes or 10 minutes from the initial ejection and then resumed were observed. As a result, it was confirmed that in each case, ink droplets were well ejected from all nozzles without clogging the nozzles.

These results confirmed that the ink (8) had good ejection stability in inkjet printing and provided a sintered body exhibiting good conductivity by low-temperature sintering (120°C for 30 minutes).

### Example 8

An ink (9) was obtained in the same manner as in Example 7 except that the dispersion solvent was changed to DL-menthol/n-hexadecane (a weight ratio of 75/25).

### Conductivity test

A sintered body with a thickness of 1.2 µm was obtained in the same manner as in Example 1 except that the ink (9) was used in place of the ink (1). The volume resistivity of the resulting sintered body was 8.8 µΩcm, indicating good conductivity.

### Ejection property test

Ejection properties were evaluated in the same manner as in Example 7 except that the ink (9) was used in place of the ink (8).

For the initial ejection properties, good ejection from all nozzles was confirmed.

For re-ejection after intermittent standing, when the ejection was stopped for 5 minutes from the initial ejection and then resumed, it was confirmed that ink droplets were well ejected from all nozzles without clogging the nozzles. In addition, also when the ejection was stopped for 10 minutes, 15 minutes, or 20 minutes from the initial ejection and then resumed, it was confirmed that ink droplets were well ejected from all nozzles without clogging the nozzles.

These results confirmed that the ink (9) had good ejection stability in inkjet printing and provided a sintered body exhibiting good conductivity by low-temperature sintering (120°C for 30 minutes).

### Example 9

An ink (10) was obtained in the same manner as in Example 7 except that the dispersion solvent was changed to DL-menthol/n-hexadecane (a weight ratio of 75/25), and the silver concentration was changed to 55 wt.%.

### Conductivity test

A sintered body with a thickness of 1.1 µm was obtained in the same manner as in Example 1 except that the ink (10) was used in place of the ink (1). The volume resistivity of the resulting sintered body was 7.0 µΩcm, indicating good conductivity.

### Ejection property test

Ejection properties were evaluated in the same manner as in Example 7 except that the ink (10) was used in place of the ink (8).

For the initial ejection properties, good ejection from all nozzles was confirmed.

For re-ejection after intermittent standing, when the ejection was stopped for 5 minutes from the initial ejection and then resumed, it was confirmed that ink droplets were well ejected from all nozzles without clogging the nozzles. In addition, also when the ejection was stopped for 10 minutes or 15 minutes from the initial ejection and then resumed, it was confirmed that ink droplets were well ejected from all nozzles without clogging the nozzles.

These results confirmed that the ink (10) had good ejection stability in inkjet printing and provided a sintered body exhibiting good conductivity by low-temperature sintering (120°C for 30 minutes).

### Example 10

An ink (11) was obtained in the same manner as in Example 7 except that the dispersion solvent was changed to DL-menthol/n-hexadecane (a weight ratio of 75/25), and the silver concentration was changed to 60 wt.%.

### Conductivity test

A sintered body with a thickness of 1.4 µm was obtained in the same manner as in Example 1 except that the ink (11) was used in place of the ink (1). The volume resistivity of the resulting sintered body was 7.5 µΩcm, indicating good conductivity.

### Ejection property test

Ejection properties were evaluated in the same manner as in Example 7 except that the ink (11) was used in place of the ink (8).

For the initial ejection properties, good ejection from all nozzles was confirmed.

For re-ejection after intermittent standing, when the ejection was stopped for 5 minutes from the initial ejection and then resumed, it was confirmed that ink droplets were well ejected from all nozzles without clogging the nozzles. In addition, also when the ejection was stopped for 10 minutes or 15 minutes from the initial ejection and then resumed, it was confirmed that ink droplets were well ejected from all nozzles without clogging the nozzles.

These results confirmed that the ink (11) had good ejection stability in inkjet printing and provided a sintered body exhibiting good conductivity by low-temperature sintering (120°C for 30 minutes).

### Comparative Example 2

An ink (12) was obtained in the same manner as in Example 7 except that the dispersion solvent was changed to cyclohexaneethanol/n-pentadecane (a weight ratio of 75/25), and the silver concentration was changed to 55 wt.%.

### Conductivity test

A sintered body with a thickness of 1.0 µm was obtained in the same manner as in Example 1 except that the ink (12) was used in place of the ink (1). The volume resistivity of the resulting sintered body was 1 x 10⁸ µΩcm, showing significant decrease in conductivity.

### Ejection property test

Ejection properties were evaluated in the same manner as in Example 7 except that the ink (12) was used in place of the ink (8).

For the initial ejection properties, good ejection from all nozzles was confirmed.

For re-ejection after intermittent standing, when the ejection was stopped for 5 minutes from the initial ejection and then resumed, it was confirmed that ink droplets were well ejected from all nozzles without clogging the nozzles. In addition, also when the ejection was stopped for 10 minutes from the initial ejection and then resumed, it was confirmed that ink droplets were well ejected from all nozzles without clogging the nozzles.

As can be seen from these results, the ink (12) had good ejection stability in inkjet printing but failed to provide a sintered body exhibiting good conductivity by low-temperature sintering (120°C for 30 minutes).

### Comparative Example 3

An ink (13) was obtained in the same manner as in Example 7 except that the dispersion solvent was changed to cyclohexanemethanol/n-pentadecane (a weight ratio of 75/25).

### Conductivity test

A sintered body with a thickness of 1.0 µm was obtained in the same manner as in Example 1 except that the ink (13) was used in place of the ink (1). The volume resistivity of the resulting sintered body was 11.0 µΩcm, indicating good conductivity.

### Ejection property test

Ejection properties were evaluated in the same manner as in Example 7 except that the ink (13) was used in place of the ink (8).

For the initial ejection properties, good ejection from all nozzles was confirmed.

For re-ejection after intermittent standing, when the ejection was stopped for 3 minutes from the initial ejection and then resumed, flight bending of ink droplets was found, confirming that the ink droplets were not normally ejected.

These results confirmed that the ink (13) provided a sintered body exhibiting good conductivity by low-temperature sintering (120°C for 30 minutes), but the ejection was unstable in inkjet printing.

### Comparative Example 4

An ink (14) was obtained in the same manner as in Example 7 except that the dispersion solvent was changed to cyclohexanemethanol/cyclohexaneethanol/n-pentadecane (a weight ratio of 60/15/25), and the silver concentration was changed to 55 wt.%.

### Conductivity test

A sintered body with a thickness of 1.0 µm was obtained in the same manner as in Example 1 except that the ink (14) was used in place of the ink (1). The volume resistivity of the resulting sintered body was 10.0 µΩcm, indicating good conductivity.

### Ejection property test

Ejection properties were evaluated in the same manner as in Example 7 except that the ink (14) was used in place of the ink (8).

For the initial ejection properties, good ejection from all nozzles was confirmed.

For re-ejection after intermittent standing, when the ejection was stopped for 3 minutes from the initial ejection and then resumed, flight bending of ink droplets was found, and when the ejection was stopped for 5 minutes from the initial ejection and then resumed, flight bending was found in a plurality of nozzles, confirming that the ink droplets were not normally ejected.

These results confirmed that the ink (14) provided a sintered body exhibiting good conductivity by low-temperature sintering (120°C for 30 minutes), but the ejection was unstable in inkjet printing.

To summarize the above, configurations and variations according to an embodiment of the present invention will be described below.
(1) An inkjet printing ink comprising surface-modified silver nanoparticles (A) and a dispersion solvent (B), wherein
   the (A) are surface-modified silver nanoparticles having a configuration in which surfaces of the silver nanoparticles are coated with a protective agent containing an amine;
   an amount of the (A) (in terms of silver) is not less than 30 wt.% of the ink; and
   the (B) comprises a secondary alcohol and/or a tertiary alcohol (b-1), and a hydrocarbon (b-2), wherein a total amount of the (b-1) and the (b-2) is not less than 70 wt.% of a total amount of the dispersion solvent (B).
(2) The ink according to (1), wherein an amount of the (A) (in terms of silver) is greater than 40 wt.% and not greater than 70 wt.% of the total amount of the ink.
(3) The ink according to (1) or (2), wherein the secondary alcohol and/or the tertiary alcohol (b-1) are/is a secondary alcohol and/or a tertiary alcohol having a boiling point of not lower than 75°C.
(4) The ink according to any one of (1) to (3), wherein the hydrocarbon (b-2) is a hydrocarbon having a boiling point of not lower than 130°C.
(5) The ink according to any one of (1) to (4), wherein the (b-1) is a secondary alcohol.
(6) An inkjet printing ink comprising surface-modified silver nanoparticles (A) and a dispersion solvent (B), wherein
   the (A) are surface-modified silver nanoparticles having a configuration in which surfaces of the silver nanoparticles are coated with a protective agent containing an amine;
   an amount of the (A) (in terms of silver) is greater than 40 wt.% and not greater than 70 wt.% of a total amount of the ink; and
   the dispersion solvent (B) comprises a secondary alcohol and/or a tertiary alcohol (b-1) having a boiling point of not lower than 185°C, and a hydrocarbon (b-2) having a boiling point of not lower than 200°C, wherein a total amount of the (b-1) and the (b-2) is not less than 70 wt.% of a total amount of the dispersion solvent (B).
(7) The ink according to (6), wherein the secondary alcohol and/or the tertiary alcohol of the (b-1) are/is an alicyclic secondary alcohol and/or an alicyclic tertiary alcohol.
(8) The ink according to (6), wherein the (b-1) is a secondary alcohol.
(9) The ink according to (6), wherein the (b-1) is an alicyclic secondary alcohol.
(10) The ink according to (6), wherein the (b-1) /is an alicyclic secondary alcohol having a boiling point of 185 to 220°C.
(11) The ink according to any one of (6) to (10), wherein the (b-2) is a chain aliphatic hydrocarbon having 15 or more (preferably from 15 to 20 and particularly preferably from 15 to 18) carbon atoms.
(12) The ink according to any one of (6) to (10), wherein the (b-2) is a chain aliphatic hydrocarbon having a boiling point of 280 to 300°C and having 15 or more (preferably from 15 to 20 and particularly preferably from 15 to 18) carbon atoms.
(13) An inkjet printing ink comprising surface-modified silver nanoparticles (A) and a dispersion solvent (B), wherein
   the (A) are surface-modified silver nanoparticles having a configuration in which surfaces of the silver nanoparticles are coated with a protective agent containing an amine;
   an amount of the (A) (in terms of silver) is from 30 to 40 wt.% of a total amount of the ink; and
   the (B) comprises a secondary alcohol and/or a tertiary alcohol (b-1), and a hydrocarbon (b-2), wherein a total amount of the (b-1) and the (b-2) is not less than 70 wt.% of a total amount of the dispersion solvent (B).
(14) The ink according to (13), wherein the secondary alcohol and/or the tertiary alcohol of the (b-1) are/is an alicyclic secondary alcohol and/or an alicyclic tertiary alcohol.
(15) The ink according to (13), wherein the (b-1) is a secondary alcohol.
(16) The ink according to (13), wherein the (b-1) is an alicyclic secondary alcohol.
(17) The ink according to (13), wherein the (b-1) is an alicyclic secondary alcohol having a boiling point of 80 to 220°C (preferably 80 to 200°C).
(18) The ink according to any one of (13) to (17), wherein the (b-2) is a chain aliphatic hydrocarbon having 15 or more (preferably from 15 to 20 and particularly preferably from 15 to 18) carbon atoms.
(19) The ink according to any one of (13) to (17), wherein the (b-2) is a chain aliphatic hydrocarbon having a boiling point of 200 to 280°C (preferably 230 to 270°C) and having 15 or more (preferably from 15 to 20 and particularly preferably from 15 to 18) carbon atoms.
(20) The ink according to any one of (1) to (19), wherein the protective agent in the (A) contains, as amines, an aliphatic monoamine (1) having 6 or more carbon atoms in total, and an aliphatic monoamine (2) having 5 or less carbon atoms in total and/or an aliphatic diamine (3) having 8 or less carbon atoms in total.
(21) An ink according to any one of (1) to (20), wherein a ratio of contents of the (b-1) and the (b-2) (the former/the latter (weight ratio)) in the (B) is from 50/50 to 95/5.
(22) The ink according to any one of (1) to (21), wherein a sintered body obtained by sintering at 120°C for 30 minutes has a volume resistivity of not greater than 15 µΩcm.
(23) A method for producing an electronic device, the method including: coating the ink described in any one of (1) to (22) onto a substrate by an inkjet printing method; and sintering.
(24) An electronic device including a sintered body of the ink described in any one of (1) to (22) on a substrate.

### Industrial Applicability

The ink according to an embodiment of the present invention can be suitably used in applications for producing electronic components (e.g., such as circuits, wiring, and electrodes) on plastic substrates using an inkjet printing method.

## Claims

1. An inkjet printing ink comprising surface-modified silver nanoparticles (A) and a dispersion solvent (B), wherein
the (A) are surface-modified silver nanoparticles having a configuration in which surfaces of the silver nanoparticles are coated with a protective agent containing an amine;
an amount of the (A) (in terms of silver) is not less than 30 wt.% of the ink; and
the (B) comprises a secondary alcohol and/or a tertiary alcohol (b-1), and a hydrocarbon (b-2), wherein a total amount of the (b-1) and the (b-2) is not less than 70 wt.% of a total amount of the dispersion solvent (B).

2. The ink according to claim 1, wherein an amount of the (A) (in terms of silver) is greater than 40 wt.% and not greater than 70 wt.% of the total amount of the ink.

3. The ink according to claim 1 or 2, wherein the secondary alcohol and/or the tertiary alcohol (b-1) are/is a secondary alcohol and/or a tertiary alcohol having a boiling point of not lower than 185°C.

4. The ink according to any one of claims 1 to 3, wherein the hydrocarbon (b-2) is a hydrocarbon having a boiling point of not lower than 200°C.

5. The ink according to any one of claims 1 to 4, wherein the secondary alcohol and/or the tertiary alcohol of the (b-1) are/is an alicyclic secondary alcohol and/or an alicyclic tertiary alcohol.

6. The ink according to any one of claims 1 to 5, wherein the protective agent in the (A) contains, as amines, an aliphatic monoamine (1) having 6 or more carbon atoms in total, and an aliphatic monoamine (2) having 5 or less carbon atoms in total and/or an aliphatic diamine (3) having 8 or less carbon atoms in total.

7. An ink according to any one of claims 1 to 6, wherein a ratio of contents of the (b-1) and the (b-2) (the former/the latter (weight ratio)) in the (B) is from 50/50 to 95/5.

8. The ink according to any one of claims 1 to 7, wherein a sintered body obtained by sintering at 120°C for 30 minutes has a volume resistivity of not greater than 15 µΩcm.

9. A method for producing an electronic device, the method including: coating the ink described in any one of claims 1 to 8 onto a substrate by an inkjet printing method; and sintering.

10. An electronic device including a sintered body of the ink described in any one of claims 1 to 8 on a substrate.
